# EUROPEAN PATENT APPLICATION

(11) **EP 2 846 355 A1**
(43) Date of publication of application: **11.03.2015**
(21) Application number: 14169730.0
(22) Date of filing: 23.05.2014
(51) Int. Cl.: H01L 25/075

(54) **Electrical substrate and process of manufacturing the same**

(30) Priority: 26.07.2013 EP 13178256
(71) Applicant: Linxens Holding, 78280 Guyancourt (FR); Deutsche Technoplast GmbH, 93086 Wörth an der Donau (DE)
(72) Inventor: Lechleiter, François, 78200 Favrieux (FR); Bauer, Hans Jürgen, 94315 Straubing (DE); Xie, Shiyong, 733687 Singapour (SG)
(74) Representative: GIE Innovation Competence Group

(57) **Abstract**

The invention relates to an electrical circuit (70) for packaging electronic components (50) and a process for manufacturing the same.

The electrical circuit (70) has a top face and a bottom face, which are its main faces. It also comprises a substrate having a conductive layer (7) and an insulating layer (1). The conductive layer (7) has electrical connection pads (9) at least partially attached to the insulating layer (1).

A casing (40) of plastic material (30) is overmolded over a portion of the substrate. A cavity (41) is made in the casing (40) for accommodating a semiconductor component (50), the cavity being opened on the top face and leaving at least a portion of the electrical connection pads (9) uncovered for connecting them to the semiconductor component (50).

## Description

### Field of the invention

The invention relates to the field of electrical circuits for packaging electronic components. It also relates to a process for manufacturing such electrical circuits.

### Background of the invention

Electrical circuits for packaging electronic components are used for mechanically supporting and electrically connecting electronic components, such as LED (Light Emitting Diode), light sensors, integrated circuits, etc.

An example of such circuit is disclosed in WO2012084291. In this document, an electrical circuit is shown which has two main faces, a top face and a bottom face, and comprises a substrate extending essentially parallel to the top and bottom face. The substrate has essentially a conductive layer made of electrically conducting material, such as copper, lying on an insulating layer made of dielectric material, such as epoxy glass. The insulating layer is located on the side of the top face of the substrate. The conductive layer is located on the side of the bottom face. Electrical connection pads are made in the conductive layer. Openings are made in the insulating layer so as to connect a semiconductor component attached on the top face side, to the connection pads, through the openings.

A purpose of the invention is to improve the packaging and the robustness of such electrical circuits.

This purpose is at least partially achieved with an electrical circuit with the features mentioned above and further having an overmolded casing made of plastic material, at least partially covering the substrate, and wherein a cavity is made in the casing for accommodating a semiconductor component, the cavity being opened on the top face and leaving at least a portion of the electrical connection pads uncovered, for connecting them to the semiconductor component.

The substrate can be flexible and processed through reel-to-reel operations and overmolding a casing allows designing and forming packaging adapted to the use of the electrical circuit. Consequently, the invention combines the productivity and mass production advantages of reel-to-reel processes with an improved robustness and the possibility to create specific packaging designs.

Other aspects and features of the invention are listed, in particular, in the claims.

### Brief description of the drawings

Other characteristics and advantages of the invention will appear from the following description and of the appending drawings.

On the drawings :
- Figures 1a to 1l represent schematically various steps of an example of process according to the invention;
- Figures 2a and 2b represent an example of electrical circuit obtained by the process illustrated Fig. 1a to 1l;
- Figures 3a and 3b represent schematically cross-sections of two embodiments of electrical circuits; and
- Figures 4a to 4e represent schematically various steps of another example of process according to the invention.

### Detailed description

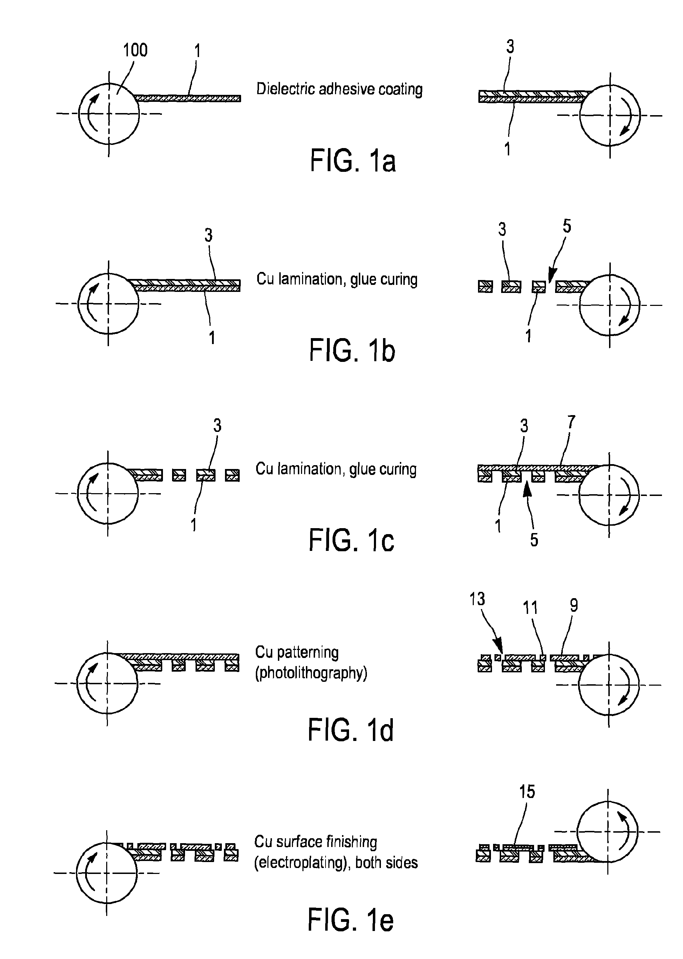

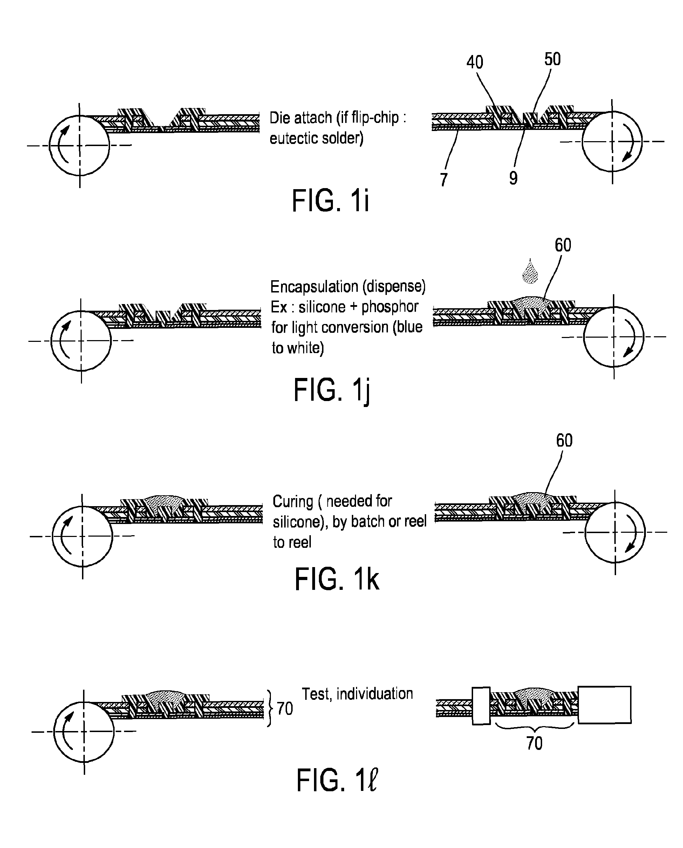

In reference to figures 1a to 1l, a non-limitative example of the manufacturing process according to the invention is described.

An insulating layer 1 is supplied from a reel 100 at Fig. 1a. This insulating layer 1 consists in a dielectric material such as epoxy glass. A glass-reinforced dielectric offers good thermo-mechanical properties and a good dimensional stability. This insulating layer 5 is for example about 110µm thick.

A dielectric adhesive or glue layer 3 is coated and/or laminated on one of the main surfaces of the insulating layer 1. This adhesive layer 3 is for example about 22µm thick.

This complex comprising the insulating layer 1 and the adhesive layer 3 is then punched at a stamping step (Fig. 1b). The openings 5 made at this stamping step are drilled though both the insulating layer 1 and the adhesive layer 3.

At the step illustrated by Fig. 1c, an electrically conductive layer 7 is laminated on the adhesive layer 3, and in particular over the openings 5. The conductive layer 7 is for example a copper layer about 68µm thick. After, the lamination, the tape comprising the conductive layer 7, the insulating layer 1 and the conductive layer 7 is heated for curing the adhesive layer 3.

This tape is then pattern through a photolithography process in order to design electrical connection pads 9, tracks 11, etc. possibly isolated from each other by gaps 13 etched in the conductive layer 7 (Fig. 1d).

Optionally, the conductive layer 7 receive, for example by electroplating, a finishing layer 15 on portions (selective coating) or on the whole surface of one or both of its sides (Fig. 1e). On the side of the conductive layer 7 which will receive semiconductor components (called top face in the following), the finishing layer 15 is for example composed of a first layer of nickel 2µm thick (directly on the copper) covered by a first silver layer 2µm thick on which semiconductor components will be connected. On the other side (the one which will correspond to the contact face of the pads 9 or bottom face), a second layer of nickel 1µm thick (directly on the copper) is covered by a second silver layer 1µm thick. Only the finishing layer 15 on the bottom face is shown on the figures.

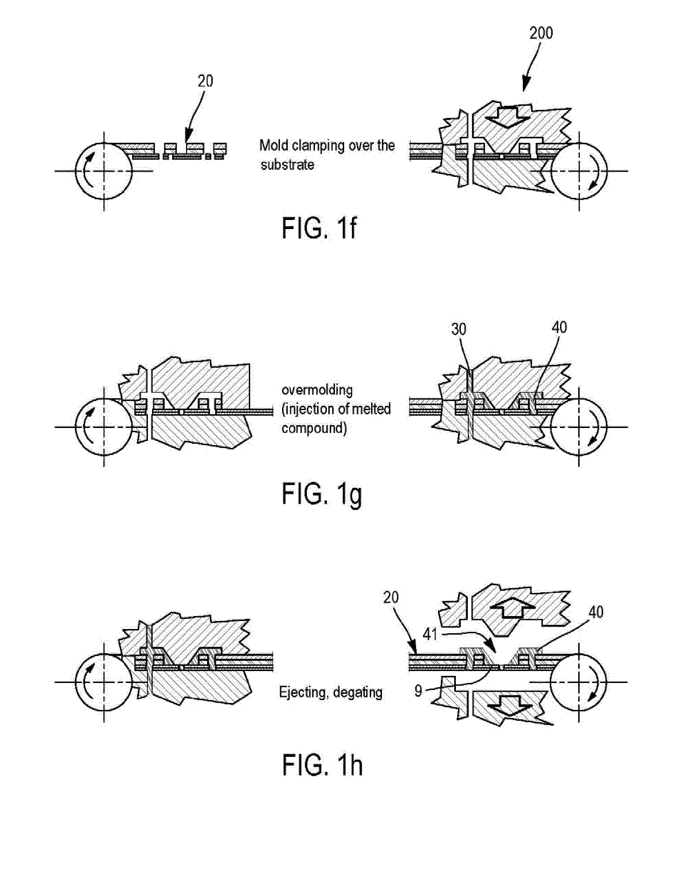

The substrate 20 resulting from these steps is then inserted in a clamping mold 200 (Fig. 1f).) At least a portion of the substrate 20 is overmolded: A melted compound, such as a melted plastic material 30 is injected in the mold 200 (Fig. 1g) in order to form a casing 40. The plastic material 30 is chosen for its high temperature resistance and its UV-resistance.

At a further step (Fig. 1h), the substrate 20 and the casing 40 are ejected from the mold 200 and degated. For the sake of simplifying the drawings, only one mold 200 and one casing 40 are represented, but of course one mold 200 can comprise several cavities each one of which corresponding to one casing 40 and /or several molds can be clamped on the substrate 20 at the same time.

A cavity 41 is made in the casing 40 for accommodating a semiconductor component. The cavity 41 is opened on the top face of the substrate 20. The cavity leaves at least a portion of the electrical connection pads 9 uncovered for connecting them to the semiconductor component.

The next steps will be exemplified in a case where the semiconductor component is a LED, but they can be easily transposed to other kinds of semiconductor component (microchip, die, etc.).

At Fig. 1i, a LED component 50 is attached and connected, for example with a flip-chip process, to electrical connection pads 9 made in the conductive layer 7. For example, an eutectic solder is used for this connection.

The component 50 is then encapsulated (Fig. Ij). When the component is a LED, the encapsulating material 60 is for example a silicone including phosphor for converting blue light to white. Optionally, the encapsulating material 60 is cured (Fig. 1k). This curing step can be carried out by batch or through a reel-to-reel process.

At another step (Fig. 1l), the electrical circuits 70 resulting from the previous steps may be individuated and tested.

When the electrical circuit obtained by the process according to the invention is used for connecting LEDs, the finishing layer (Fig. 1e) can be made selectively with a highly reflective plating on the side (top face) that will receive the LED (in order to enhance the light efficiency in the case of LED packaging). In particular, the connection pads 9, on this side has a sliver-like reflective surface, for optimizing the reflectance. A silver layer is particularly adapted for such an application. The finishing layer 15 on the other side (bottom face) may be optimized for improving the efficiency of the soldering or attachment to a heat management system (heat sink). Furthermore, the insulating layer 1 and the plastic material 30 are advantageously substantially white for reflecting light.

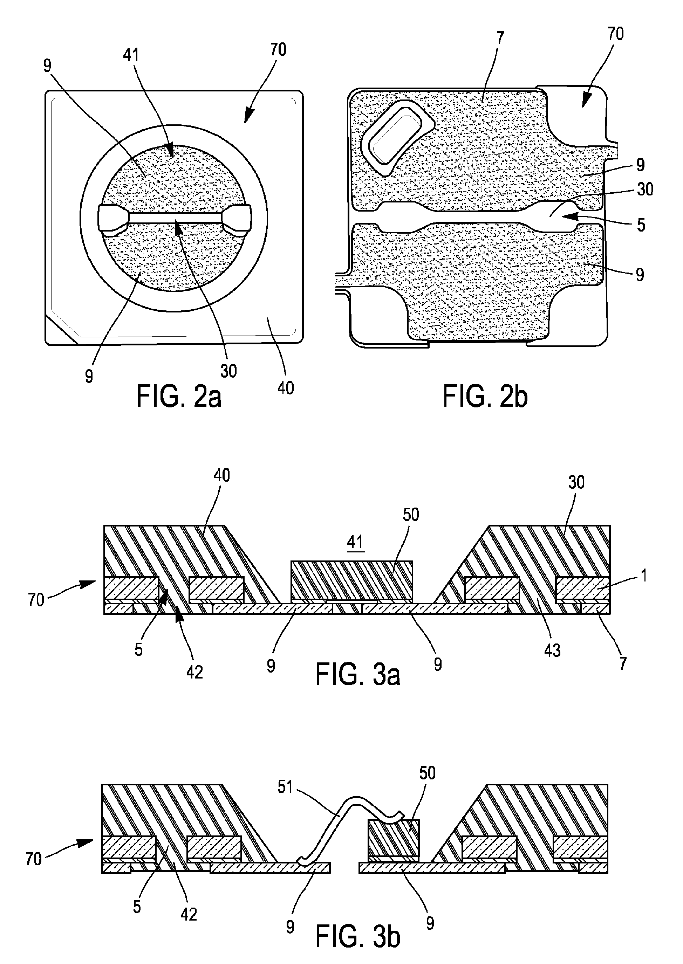

Figures 2a and 2b, respectively show top and bottom faces of an example of electrical circuit 70 obtained at step 1e. (i e. before attachment and connection of a semiconductor component 50).

The cavity 41 in the casing 40 has substantially a cup shape for reflecting light emitted by the LED (the LED is not shown on Fig. 2a).

This electrical circuit 70 has contact pads 9 which are flush with the bottom face (Fig. 2b). This can be an advantage for improving the heat dissipation through a heat management system on which the electrical circuit 70 is attached and contacted.

The electrical circuit 70 comprises one opening 5 through both the conductive layer and the insulating layer 1. The plastic material 30 fills this opening 5 and electrically isolates the connection pads 9 from each other. The opening 5 in the conductive layer 7 between the connection pads 9 (anode/cathode) is filled with the plastic material 30 to avoid any leakage when the cup-shape cavity 41 is filled with a liquid product (like a resin, or a silicone, or phosphor containing products).

As better shown on Figs. 3a and 3b, the electrical circuit 70 comprises rivets 42 made of plastic material. Indeed, openings 5 through both the conductive layer 7 and the insulating layer 1 are used for injected the plastic material 30. The openings 5 being larger in the conductive layer 7 than in the insulating layer 1, a mushroom-shape is obtained which provides kind of plastic rivets 42. The head 43 of these plastic rivets 42 is as thick as the conductive layer. This allows to get rid of top surface tensions from the insulating layer 1, and of the peel strength at the interface between the plastic material 30 and the insulating layer 1. The reliability of the electrical circuit 70 is increased, in particular with regard to the cohesion through the various layers. Another advantage lies in the fact that there is no need for a chemical compatibility in order to have a good mechanical cohesion between the casing 40 and the rest of the structure since rivets 42 provide hooking and mechanical connections. The bottom face is maintained flat (for a better heat conduction through a heat management system for example). On these figures 3a and 3b, one can see that there is a direct path between the semiconductor component 50 and the heat management system (not shown on these figures but which would be attached on the bottom face).

The top face of the conductive layer 7 is flat too for a more reliable connection to the semiconductor component 50.

Such a structure is suitable for receiving a chip on one side, while the other side may be tailored (with a surface finishing for example) for providing either pads for components, or pads for a connector (e.g. a spring loaded connector, like for smart-cards).

Figs. 3a and 3b also show two different type of connection of the semiconductor component 50 to the pads 9. On Fig. 3a, the illustrated connection is a flip-chip connection with solder (eutectic soldering or solder paste) between the semiconductor component 50 and the pads 9. On Fig. 3b, the illustrated connection is a wire bonding connection with wires 51 between pads of the semiconductor component 50 and the connection pads 9 of the electrical circuit 70.

The electrical circuit 70 obtained by the process discrided above can be used for example for applications in pre-molded Flex Etched Circuits for chip packaging.

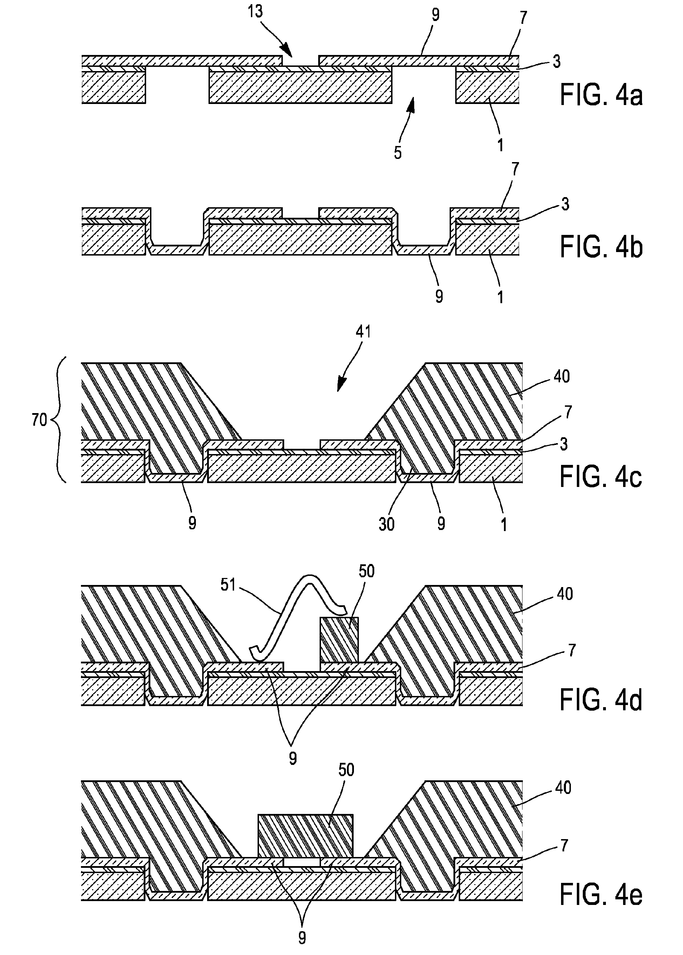

Another embodiment is illustrated on figures 4a to 4f.

The tape shown on Fig. 4a is similar to the one obtained at Fig. 1d. At the step illustrated on Fig. 4b, the conductive layer 7 is deformed for example by stamping or roll-to-roll process. Then one or both surfaces of the conductive layer 7 optionally receive finishing layers 15 as explained in relation to Fig. 1e. A casing 40 is further overmolded as explained in relation to Figs. 1i to 1l (see fig. 4c). In the electrical circuit 70 obtained by this process, the conductive layer 7 is oriented toward the top face in the cavity 41 and is flush with the bottom face in at least a location corresponding to a connection pad 9.

In this example, the conductive layer 7 is a copper layer about 32µm thick. A soft copper is advantageously chosen for its ability to deform. The insulating layer 1 is made of polyimide and is about 50µm thick. Polyimide is chosen for its high dielectric performances. The adhesive layer 3 is about 22µm thick. In the finishing layers (not shown on figures 4c-4f), the nickel layer is about 1µm on both sides of the conductive layer 7 and the silver layer is 1.5 µm thick on the top side of the conductive layer 7 and 3µm thick on the bottom side of the conductive layer 7.

The thickness of the insulating layer 1 is chosen for its ability not to deform during the deformation step of the conductive layer 7.

As can be seen on Fig. 4c, the plastic material 30 of the casing 40 is injected on the copper side. This reduces risks of delamination.

Furthermore, a hooking effect is provided by the conductive layer 7 deformed in the openings 5 and the overmolding of plastic material 30 in these openings 5. On top of this effect, if the conductive layer 7 expands, during thermal cycling, the adhesive layer 3 between the conductive layer 7 and the insulating layer 1 remains compliant. These advantages make the structure more hermetic. There is less risk of propagation of particles or chemicals (like sulfur) inside the package, resulting in a better reliability and light consistency. This make the electrical circuit 70 according to the invention more reliable than Plastic Leadless Chip Carrier (PLCCs) of the prior art. The electrical circuit 70 according to the invention is also thinner than PLCCs of the prior art.

Similarly to the previous embodiment, the semiconductor component 50 may be connected to connection pads 9 of the conductive layer 7 by either a wire bonding (Fig. 4d) or a flip-chip (Fig. 4e) technology. On these figures 4d and 4e, one can see that there is a direct path between the semiconductor component 50 and the heat management system (not shown on these figures but which would be attached on the bottom side).

The electrical circuit 70 obtained by the process disclosed in relation to Fig. 4a-4e can be used for example for applications in Quad Flat No Leads - Flex Etched Circuits for chip packaging.

## Claims

1. Electrical circuit with a top face and a bottom face, and comprising a substrate (20) having
- a conductive layer (7) of electrically conducting material, with electrical connection pads (9) made in the layer of electrically conducting material, and
- an insulating layer (1) of dielectric material, the conductive layer (7) being at least partially attached to the insulating layer (1),
wherein an overmolded casing (40) made of plastic material (30), at least partially covers the substrate (20), and wherein a cavity (41) is made in the casing (40) for accommodating a semiconductor component (50), the cavity (50) being opened on the top face and leaving at least a portion of the electrical connection pads (9) uncovered for connecting them to the semiconductor component (50).

2. Electrical circuit according to claim 1, wherein the contact pads (9) are flush with the bottom face.

3. Electrical circuit according to claim 1, comprising at least one opening (5) through both the conductive layer (7) and the insulating layer (1), the plastic material (30) at least partially filling the openings.

4. Electrical circuit according to any preceding claim, comprising rivets (42) made of plastic material (30).

5. Electrical circuit according to any preceding claim, wherein the plastic material (30) reflects light.

6. Electrical circuit according to any preceding claim, wherein the semiconductor component (50) is a LED or a light sensor.

7. Electrical circuit according to claim 6, wherein the cavity (41) in the casing (40) has substantially a cup shape for reflecting light emitted by the LED.

8. Electrical circuit according to any preceding claim, wherein the conductive layer (7) is oriented toward the top face in the cavity (41) and is flush with the bottom face in at least a location corresponding to a contact pad (9).

9. Process for manufacturing an electrical circuit according to any preceding claim, comprising the steps of:
- providing a flexible substrate (20) having a conductive layer (7) of electrically conducting material, with electrical connection pads (9) made in the layer of electrically conducting material, and an insulating layer (1) of dielectric material, the conductive layer being at least partially attached to the insulating layer (1),
- overmolding a casing (40) of plastic material (30) over at least a portion of the substrate (20), while forming in the overmolded casing (40), a cavity (41) for accommodating a semiconductor component (50), the cavity (41) being opened on the top face and leaving at least a portion of the electrical connection pads (9) uncovered for connecting them to the semiconductor component (50).

10. Process according to claim 10, wherein the step consisting in overmolding the casing (40) is performed on a flexible substrate (20) processed through reel-to-reel operations.

11. Process according to claim 9 or 10; wherein the insulating layer (1) has two main faces and the conductive layer (9) at least partially covers one of the two main faces of the insulating layer (1) and is deformed in at least one opening (5) made in the insulating layer (1) up to becoming flush with the other of the two main faces of the insulating layer (1).
